(19) Europäisches Patentamt
European Patent Office
Office européen des brevets

(11) **EP 3 223 381 A1**

(12) **EUROPEAN PATENT APPLICATION**

(43) Date of publication:
**27.09.2017 Bulletin 2017/39**

(51) Int Cl.:
*H02H 3/16* (2006.01)   *H02H 3/26* (2006.01)
*H02H 3/32* (2006.01)   *H02H 3/33* (2006.01)
*H02H 1/00* (2006.01)

(21) Application number: **17160566.0**

(22) Date of filing: **13.03.2017**

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**
Designated Extension States:
**BA ME**
Designated Validation States:
**MA MD**

(30) Priority: **14.03.2016 US 201615069595**

(71) Applicant: **Rosemount Aerospace Inc.
Burnsville MN 55306-4898 (US)**

(72) Inventor: **SCHRAM, Kenneth J.
Eden Prairie, MN 55347 (US)**

(74) Representative: **Hughes, Andrea Michelle
Dehns
St Bride's House
10 Salisbury Square
London EC4Y 8JD (GB)**

(54) **AC POWER HEATER SHORT-TO-CHASSIS GROUND DETECTION CIRCUIT**

(57) Systems and methods for electronics systems are provided herein. An electronics system may comprise a heating circuit (12) and a fault detection system (14). The heating circuit may include a heating element (50). The fault detection system may include a current-to-voltage converter (20), a voltage level detector (30), and a controllable switch (40) connected in series with the heating element, the controllable switch in electronic communication with the voltage level detector. A fault may be detected in response to a secondary voltage being greater than a threshold value.

FIG. 1

EP 3 223 381 A1

**Description**

**FIELD**

The disclosure generally relates to electronics systems, and more particularly to the design of a fault detection system for electronics systems in aircraft.

**BACKGROUND**

Modem aircraft may utilize various electronics systems, such as ice detection systems, deicing systems, air data probes, etc. Various electronics systems may include a heating element. A voltage potential may be applied across the heating element to draw current through the heating element and convert electrical energy to thermal energy.

**SUMMARY**

A fault detection system may comprise a current transformer; a current-to-voltage converter (CVC) configured to receive a secondary current from the current transformer; a voltage level detector configured to receive a signal from the CVC; and a controllable switch, the controllable switch in electronic communication with the voltage level detector.
In various embodiments, the CVC may include a resistor in electronic communication with the current transformer. The secondary current may flow through the resistor. The signal may comprise a secondary voltage signal. A secondary voltage may exist across the resistor in response to the secondary current, the secondary voltage signal corresponding to the secondary voltage, and the secondary current being based on a difference between a first current and a second current. The voltage level detector may receive the secondary voltage signal from the CVC. The voltage level detector may determine if the secondary voltage is greater than a threshold value. The controllable switch may be moved to an open position in response to the secondary voltage being greater than the threshold value. The controllable switch may be coupled, in series, between the heating element and the current transformer.
An ice detection system may comprise a current transformer, the current transformer configured to provide a means of comparing a first current and a second current, wherein the second current is less than the first current in response to a fault in the ice detection system; a heating element comprising a first resistance; a controllable switch in electronic communication with the current transformer and in electronic communication with the heating element, the controllable switch connected in series with the current transformer and the heating element, wherein the first current is configured to flow from the current transformer, through the controllable switch, and through the heating element; a current-to-voltage converter (CVC) in electronic communication with the current transformer; and a voltage level detector in electronic communication with the CVC and in electronic communication with the controllable switch.
In various embodiments, the CVC may comprise a resistor configured to receive a secondary current from the current transformer, the secondary current being based on a difference between the first current and the second current. A secondary voltage may exist across the resistor. The voltage level detector may be configured to receive the secondary voltage from the CVC. The voltage level detector may be configured to determine if the secondary voltage is greater than a threshold value. The controllable switch may be configured to move to an open position in response to the secondary voltage being greater than the threshold value. The controllable switch may receive a disable signal in response to the secondary voltage being greater than the threshold value. The voltage level detector may be configured to send a fault signal in response to the secondary voltage being greater than the threshold value. The CVC may include an analog-to-digital converter (ADC) configured to convert the secondary voltage from an analog signal to a digital signal.
A method of detecting a fault in a heating circuit may comprise: generating, by a current transformer, a secondary current, the secondary current being based on a difference between a first current and a second current; measuring a voltage across a resistor, the secondary current flowing through the resistor; determining if the voltage is greater than a threshold value; and sending a disable signal to a controllable switch in response to the voltage being greater than the threshold value, wherein the controllable switch moves to an open position in response to receiving the disable signal.
In various embodiments, the current transformer may be connected in series with a heating element. A magnitude of the secondary current may be zero in response to a first alternating current being equal to a second alternating current.
The foregoing features, elements, steps, or methods may be combined in various combinations without exclusivity, unless expressly indicated herein otherwise. These features, elements, steps, or methods as well as the operation of the disclosed embodiments will become more apparent in light of the following description and accompanying drawings.

**BRIEF DESCRIPTION OF THE DRAWINGS**

The subject matter of the present disclosure is particularly pointed out and distinctly claimed in the concluding portion of the specification. A more complete understanding of the present disclosure, however, may best be obtained by referring to the detailed description and claims when considered in connection with the drawing figures, wherein like numerals denote like elements.

FIG. 1 illustrates a schematic view of an electronics system comprising a heating circuit and a fault detection system, in accordance with various embodiments;

FIG. 2 illustrates a schematic view of an electronics system of FIG. 1 having a fault, in accordance with various embodiments;

FIG. 3 illustrates method of detecting a fault in a heating circuit, in accordance with various embodiments;

FIG. 4 illustrates a schematic view of a current-to-voltage converter having a resistor, in accordance with various embodiments; and

FIG. 5 illustrates a schematic view of an electronics system comprising a heating circuit and a fault detection system, the fault detection system comprising an analog-to-digital converter.

**DETAILED DESCRIPTION**

The detailed description of various embodiments herein makes reference to the accompanying drawings, which show various embodiments by way of illustration. While these various embodiments are described in sufficient detail to enable those skilled in the art to practice the inventions, it should be understood that other embodiments may be realized and that logical, chemical and mechanical changes may be made without departing from the scope of the invention as defined by the claims. Thus, the detailed description herein is presented for purposes of illustration only and not of limitation. For example, the steps recited in any of the method or process descriptions may be executed in any order and are not necessarily limited to the order presented. Furthermore, any reference to singular includes plural embodiments, and any reference to more than one component or step may include a singular embodiment or step. Also, any reference to attached, fixed, connected or the like may include permanent, removable, temporary, partial, full and/or any other possible attachment option. Additionally, any reference to without contact (or similar phrases) may also include reduced contact or minimal contact.

In the detailed description herein, references to "one embodiment", "an embodiment", "various embodiments", etc., indicate that the embodiment described may include a particular feature, structure, or characteristic, but every embodiment may not necessarily include the particular feature, structure, or characteristic. Moreover, such phrases are not necessarily referring to the same embodiment. Further, when a particular feature, structure, or characteristic is described in connection with an embodiment, it is submitted that it is within the knowledge of one skilled in the art to affect such feature, structure, or characteristic in connection with other embodiments whether or not explicitly described. After reading the description, it will be apparent to one skilled in the relevant art(s) how to implement the disclosure in alternative embodiments.

System program instructions and/or controller instructions may be loaded onto a non-transitory, tangible computer-readable medium having instructions stored thereon that, in response to execution by a controller, cause the controller to perform various operations. The term "non-transitory" is to be understood to remove only propagating transitory signals per se from the claim scope and does not relinquish rights to all standard computer-readable media that are not only propagating transitory signals per se.

As used herein, "electronic communication" means communication of electronic signals with physical coupling (e.g., "electrical communication" or "electrically coupled") or without physical coupling and via an electromagnetic field (e.g., "inductive communication" or "inductively coupled" or "inductive coupling").

Modem aircraft may utilize various electronics systems, such as ice detection systems, deicing systems, and air data probes, for example. Various electronics systems may include a heater circuit comprising a heating element. A voltage potential may be applied across the heating element (for example, a resistance element such as an electrical resistor) to draw current through the heating element and to convert electrical energy to thermal energy. Such heater circuits may fault (short circuit) to a chassis ground and fail. Typical heater circuits may not be able to detect this fault condition. Thus, an electronics system having a heater circuit with a ground fault detection system is provided herein, in accordance with various embodiments. The current going to the heater circuit is compared with the current going out the heater circuit. A fault is detected based upon this comparison.

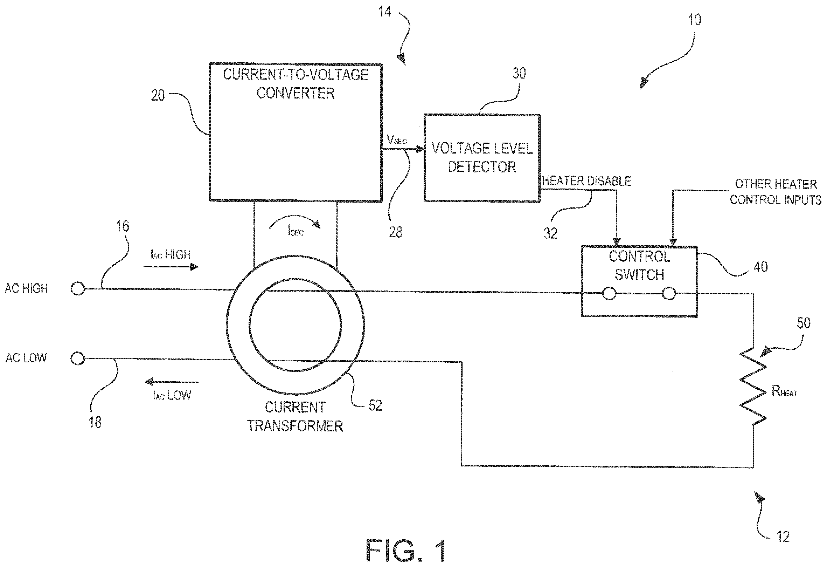

With reference to FIG. 1, an electronics system 10 comprising a heating circuit 12 and a fault detection system 14 is illustrated, in accordance with various embodiments. As will become apparent, heating circuit 12 is in electronic communication with fault detection system 14. Heating circuit 12 may include heating element 50. Heating element 50 may comprise a resistive element, or a resistor. Heating element 50 may comprise a resistance $R_{HEAT}$ (also referred to herein as a first resistance). Electrical energy may be converted to thermal energy via heating element 50. Heating element 50 may receive current from a voltage source via wire 16 and wire 18. Such current may flow through wire 16, through heating element 50 and into wire 18. Such current may flow through wire 18, through heating element 50 and into wire 16. In various embodiments, such current may comprise an alternating current (AC). Thus, a positive terminal of a voltage source may be in electronic communication with wire 16 (i.e., via terminal AC HIGH) and a negative terminal of the voltage source in electronic communication with wire 18 (i.e., via terminal AC LOW). In various embodiments, wire 16 and wire 18 may comprise a conductive metal, such as copper for example. In various embodiments, wire 16 and wire 18 may be protected via an insulator.

In various embodiments, fault detection system 14 may include a current transformer 52. A first current (i.e., current magnitude $I_{AC}$ HIGH) may flow through current transformer 52. A second current (i.e., current magnitude $I_{AC}$ LOW) may flow through current transformer 52. The first current and the second current may be out of phase by one hundred and eighty degrees (180°). Current transformer 52 may produce a secondary current comprising a magnitude $I_{SEC}$. Current magnitude $I_{SEC}$ may be proportional to the current magnitude in the transformer primary, in accordance with equation 1:

$$I_{SEC} = K(I_{AC-HIGH} - I_{AC-LOW}) \qquad\qquad \text{EQ. 1}$$

The current magnitude $I_{SEC}$ may be greater than zero in response to $I_{AC}$ HIGH being greater than or less than $I_{AC}$ HIGH. The current magnitude $I_{SEC}$ may be zero in response to $I_{AC}$ HIGH being equal to $I_{AC}$ HIGH. K may be a constant which may depend on the design of current transformer 52. In this manner, $I_{SEC}$ may be based upon a difference between $I_{AC}$ HIGH and $I_{AC}$ LOW. Stated another way, $I_{SEC}$ may be based upon a difference between the first current and the second current.

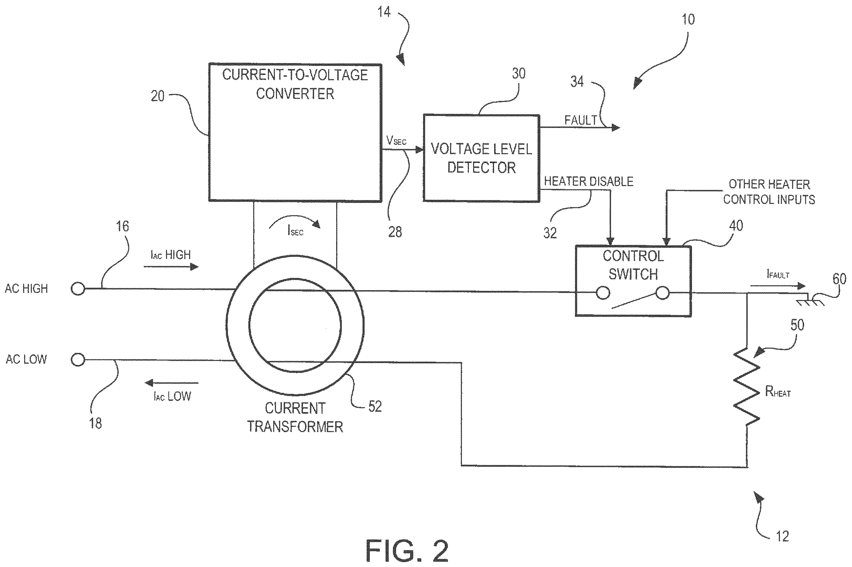

In various embodiments, fault detection system 14 may include a controllable switch 40. Controllable switch 40 may be connected in series with current transformer 52 and heating element 50. Controllable switch 40 may receive inputs wherein controllable switch 40 moves from a closed position, as illustrated in FIG. 1, to an open position, as illustrated in FIG. 2, in response to the inputs. Controllable switch 40 may receive a signal (also referred to herein as a disable signal) 32 from voltage level detector 30. In this regard, controllable switch 40 may be in electronic communication with voltage level detector 30.

In various embodiments, fault detection system 14 may include voltage level detector 30. In various embodiments, voltage level detector 30 may comprise a controller. Voltage level detector 30 may receive a signal (also referred to herein as a secondary voltage signal) 28. Voltage level detector 30 may determine if signal 28 is greater than a threshold value. The threshold value may be a predetermined threshold value. The threshold value may be determined such that noise in the current flowing through heating circuit 12 tends not be detected as a fault. For example, the threshold value may comprise between ten millivolts and two hundred millivolts (0.01 - 0.2 V). Voltage level detector 30 may send signal 32 to controllable switch 40 in response to signal 28 being greater than the threshold value.

In various embodiments, fault detection system 14 may include current-to-voltage converter (CVC) 20. CVC 20 may determine if a current (i.e., $I_{AC}$ HIGH) flowing through current transformer 52 is equal to a current (i.e., $I_{AC}$ LOW) flowing through current transformer 52. Generally, current flowing into heating circuit 12 (e.g., via terminal AC HIGH) is equal to current flowing out heating circuit 12 (e.g., via terminal AC LOW).

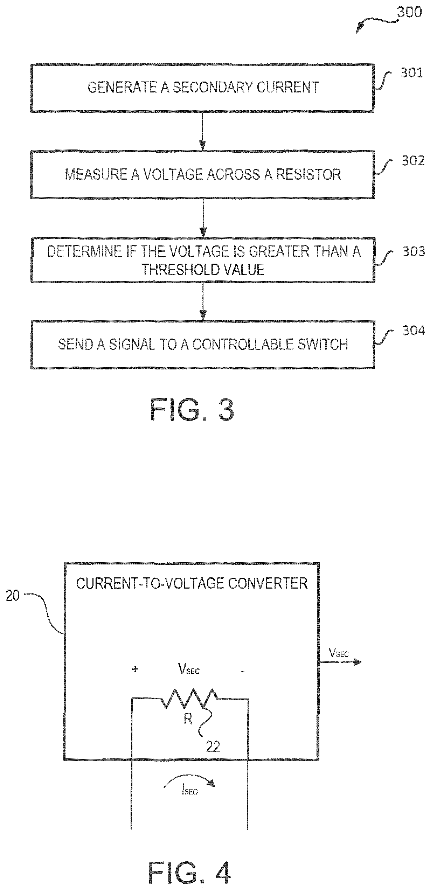

With reference to FIG. 4, current-to-voltage converter (CVC) 20 comprising a resistor 22 is illustrated, in accordance with various embodiments. CVC 20 may include a resistor 22. Resistor 22 may comprise a resistance R (also referred to herein as a second resistance). Resistor 22 may be in electronic communication with current transformer 52. In this regard, a current (i.e., current $I_{SEC}$) may flow through resistor 22. Accordingly, a voltage (i.e., voltage $V_{SEC}$) may be detected or measured across resistor 22. Voltage $V_{SEC}$ may be measured via any suitable method. As is well known by one having ordinary skill in the present art, voltage $Y_{SEC}$ may exist across resistor 22 in response to current $I_{SEC}$ and vice-versa. Stated another way, the voltage potential across a resistor is zero when there is no current flow through the resistor, as is taught by Ohm's Law. In this regard, resistor 22 may be configured to provide means of measuring the difference between the magnitude of current $I_{AC}$ HIGH and the magnitude of current $I_{AC}$ LOW. In this regard, resistor 22 may be configured to provide means of detecting a fault in heating circuit 12.

With reference to FIG. 2, the electronics system 10 of FIG. 1 is illustrated having a fault, in accordance with various embodiments. As previously mentioned, under various circumstances heating circuit 12 may contact a ground 60. Although, illustrated as being located between controllable switch 40 and heating element 50, the fault may be located in any location of electronics system 10. In various embodiments, ground 60 may comprise a chassis. In response to a conductive portion of heating circuit 12 (i.e., wire 16) contacting ground 60 a current (i.e., current $I_{FAULT}$) may flow from heating circuit 12 to ground 60. In this manner, a portion of current $I_{AC}$ HIGH may flow into ground 60 and thus, current $I_{AC}$ HIGH will be greater than current $I_{AC}$ LOW. Furthermore, voltage level detector 30 may detect, via signal 28, that current $I_{AC}$ HIGH is greater than current $I_{AC}$ LOW and send signal 32 to controllable switch 40, wherein in response to signal 32 controllable switch moves to an open position as illustrated in FIG. 2. In response to controllable switch 40 moving to an open position, heating circuit 12 may comprise an open circuit and current would not flow through controllable switch 40. Stated another way, current $I_{FAULT}$ and current $I_{AC}$ LOW comprise a current of zero Amperes in response to controllable switch 40 moving to an open position. In this regard, fault detection system 14 may prevent energy from heating circuit 12 from draining into ground 60. Similarly, fault detection system 14 may provide a means of detecting a fault and improving efficiency of heating circuit 12.

In various embodiments, in response to a fault being detected in heating circuit 12, a fault signal 34 may be sent from voltage level detector 30. Fault signal 34 may be sent to a controller in a vehicle such as an aircraft. Fault signal 34 may be used to indicate to an operator or an aircraft system that a fault has been detected in heating circuit 12. In various embodiments, fault signal 34 may comprise a Boolean data type.

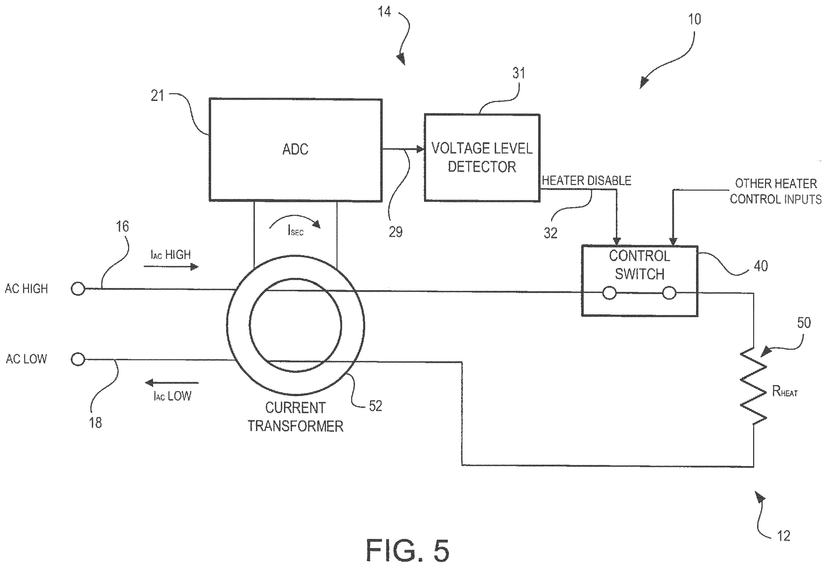

With reference to FIG. 5, fault detection system 14 comprising an analog-to-digital converter (ADC) 21 is illustrated, in accordance with various embodiments. In various embodiments, ADC 21 may be similar to CVC 20 (see FIG. 1). Fault detection system 14 may comprise voltage level detector 31. Voltage level detector 31 may be similar to voltage level detector 30 (see FIG. 1). ADC 21 may convert a voltage (i.e., voltage $V_{SEC}$) across resistor 22 from an analog signal to a digital signal. Signal 29 may comprise the digital signal based on said voltage. ADC 21 may be in electronic communication with voltage level detector 31. Voltage level detector 31 may receive signal 29. Voltage level detector 31 may determine if signal 29 is greater than a threshold value. In various embodiments, CVC 20 (see FIG. 1) may comprise or include ADC 21.

With reference to FIG. 3, a method 300 of detecting a fault in a heating circuit is provided, in accordance with various embodiments. Method 300 may include generating a secondary current in step 301. Method 300 may include measuring a voltage across a resistor in step 302. Method 300 may include determining if the voltage is greater than a threshold value in step 303. Method 300 may include sending a signal to a controllable switch in step 304.

In various embodiments, with additional reference to FIG. 1, step 301 may include generating, by current transformer 52, secondary current $I_{SEC}$. Step 302 may include measuring voltage $V_{SEC}$ across resistor 22 (see FIG. 4). The measuring may be performed by current to voltage converter 20. Step 303 may include determining if the voltage $V_{SEC}$ is greater than a threshold value. Step 304 may include sending a disable signal (i.e., signal 32) to controllable switch 40 in response to the secondary voltage (i.e., signal 28) being greater than the threshold value, wherein controllable switch 40 moves to an open position in response to the sending. In various embodiments, the sending may be performed by voltage level detector 30.

Benefits, other advantages, and solutions to problems have been described herein with regard to specific embodiments. Furthermore, the connecting lines shown in the various figures contained herein are intended to represent various functional relationships and/or physical couplings between the various elements. It should be noted that many alternative or additional functional relationships or physical connections may be present in a practical system. However, the benefits, advantages, solutions to problems, and any elements that may cause any benefit, advantage, or solution to occur or become more pronounced are not to be construed as critical, required, or essential features or elements of the inventions. The scope of the inventions is accordingly to be limited by nothing other than the appended claims, in which reference to an element in the singular is not intended to mean "one and only one" unless explicitly so stated, but rather "one or more." Moreover, where a phrase similar to "at least one of A, B, or C" is used in the claims, it is intended that the phrase be interpreted to mean that A alone may be present in an embodiment, B alone may be present in an embodiment, C alone may be present in an embodiment, or that any combination of the elements A, B and C may be present in a single embodiment; for example, A and B, A and C, B and C, or A and B and C. Different cross-hatching is used throughout the figures to denote different parts but not necessarily to denote the same or different materials.

**Claims**

1. A fault detection system comprising:

   a current transformer (52);
   a current-to-voltage converter CVC (20) configured to receive a secondary current from the current transformer;
   a voltage level detector (30) configured to receive a signal from the CVC; and
   a controllable switch (40), the controllable switch in electronic communication with the voltage level detector.

2. The fault detection system of claim 1, wherein the CVC (20) includes a resistor (22) in electronic communication with the current transformer.

3. The fault detection system of claim 2, wherein the secondary current flows through the resistor.

4. The fault detection system of claim 3, wherein the signal comprises a secondary voltage signal.

5. The fault detection system of claim 4, wherein a secondary voltage exists across the resistor in response to the secondary current, the secondary voltage signal corresponding to the secondary voltage, and the secondary current being based on a difference between a first current and a second current.

6. The fault detection system of claim 5, wherein the voltage level detector receives the secondary voltage signal from the CVC.

7. The fault detection system of claim 6, wherein the voltage level detector determines if the secondary voltage is greater than a threshold value.

8. The fault detection system of claim 7, wherein the controllable switch is moved to an open position in response to the secondary voltage being greater than the threshold value.

9. An ice detection system comprising:

a heating element (50) comprising a first resistance; and a fault detection system (14) as claimed in any preceding claim;
the current transformer configured to provide a means of comparing a first current and a second current, wherein the second current is less than the first current in response to a fault in the ice detection system; and
the controllable switch (40) connected in series with the current transformer (52) and the heating element (50), wherein the first current is configured to flow from the current transformer, through the controllable switch, and through the heating element.

10. The ice detection system of claim 9, wherein the controllable switch receives a disable signal in response to the secondary voltage being greater than the threshold value.

11. The ice detection system of claim 10, wherein the voltage level detector is configured to send a fault signal in response to the secondary voltage being greater than the threshold value.

12. The ice detection system of claim 11, wherein the CVC includes an analog-to-digital converter (ADC) configured to convert the secondary voltage from an analog signal to a digital signal.

13. A method of detecting a fault in a heating circuit, comprising:

generating, by a current transformer, a secondary current, the secondary current being based on a difference between a first current and a second current;
measuring a voltage across a resistor, the secondary current flowing through the resistor;
determining if the voltage is greater than a threshold value; and
sending a disable signal to a controllable switch in response to the voltage being greater than the threshold value, wherein the controllable switch moves to an open position in response to receiving the disable signal.

14. The method of claim 13, wherein the current transformer is connected in series with a heating element.

15. The method of claim 14, wherein a magnitude of the secondary current is zero in response to a first alternating current being equal to a second alternating current.

FIG. 1

FIG. 2

300

```
┌─────────────────────────────────────────────┐
│         GENERATE A SECONDARY CURRENT          │  301
└─────────────────────────────────────────────┘
                      │
                      ▼
┌─────────────────────────────────────────────┐
│        MEASURE A VOLTAGE ACROSS A RESISTOR    │  302
└─────────────────────────────────────────────┘
                      │
                      ▼
┌─────────────────────────────────────────────┐
│   DETERMINE IF THE VOLTAGE IS GREATER THAN A  │  303
│                THRESHOLD VALUE                │
└─────────────────────────────────────────────┘
                      │
                      ▼
┌─────────────────────────────────────────────┐
│      SEND A SIGNAL TO A CONTROLLABLE SWITCH   │  304
└─────────────────────────────────────────────┘
```

FIG. 3

20

CURRENT-TO-VOLTAGE CONVERTER

$+$     $V_{SEC}$     $-$     $V_{SEC}$

$R$

22

$I_{SEC}$

FIG. 4

FIG. 5

10

14

OTHER HEATER CONTROL INPUTS

CONTROL SWITCH — 40

50

$R_{HEAT}$

12

HEATER DISABLE

32

VOLTAGE LEVEL DETECTOR — 31

29

ADC — 21

$I_{SEC}$

CURRENT TRANSFORMER — 52

$I_{AC}$ HIGH

16

AC HIGH

$I_{AC}$ LOW

18

AC LOW

10

Europäisches
Patentamt

European
Patent Office

Office européen
des brevets

# EUROPEAN SEARCH REPORT

Application Number

EP 17 16 0566

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP 2002 199575 A (COPYER CO) 12 July 2002 (2002-07-12) | 1-8, 13-15 | INV. H02H3/16 |
| Y | * the whole document * | 9-15 | H02H3/26 H02H3/32 |
| Y | US 5 361 183 A (WIESE EARL G [CA]) 1 November 1994 (1994-11-01) * abstract; claims 1-5 * | 9-15 | H02H3/33 H02H1/00 |
| X | KR 2011 0048831 A (YOON DONG MIN [KR]) 12 May 2011 (2011-05-12) | 1 | |
| A | * the whole document * | 2-15 | |
| A | US 2014/146424 A1 (SUEISHI NAOKI [JP]) 29 May 2014 (2014-05-29) * paragraphs [0047] - [0049]; figure 3 * * abstract * | 1-15 | |
| Y | US 2007/208520 A1 (ZHANG BIN [US] ET AL) 6 September 2007 (2007-09-06) * abstract; claims 7,9,10; figure 1 * | 12 | |

TECHNICAL FIELDS
SEARCHED      (IPC)

H02H

The present search report has been drawn up for all claims

| Place of search | Date of completion of the search | Examiner |
|---|---|---|
| Munich | 28 July 2017 | Lehnberg, Christian |

CATEGORY OF CITED DOCUMENTS

X : particularly relevant if taken alone
Y : particularly relevant if combined with another
　　document of the same category
A : technological background
O : non-written disclosure
P : intermediate document

T : theory or principle underlying the invention
E : earlier patent document, but published on, or
　　after the filing date
D : document cited in the application
L : document cited for other reasons

..............................................................................................
& : member of the same patent family, corresponding
　　document

EPO FORM 1503 03.82 (P04C01)

## ANNEX TO THE EUROPEAN SEARCH REPORT
## ON EUROPEAN PATENT APPLICATION NO.

EP 17 16 0566

This annex lists the patent family members relating to the patent documents cited in the above-mentioned European search report.
The members are as contained in the European Patent Office EDP file on
The European Patent Office is in no way liable for these particulars which are merely given for the purpose of information.

28-07-2017

| Patent document cited in search report | | Publication date | Patent family member(s) | | Publication date |
|---|---|---|---|---|---|
| JP 2002199575 | A | 12-07-2002 | NONE | | |
| US 5361183 | A | 01-11-1994 | AT | 160472 T | 15-12-1997 |
| | | | DE | 69406924 D1 | 02-01-1998 |
| | | | DE | 69406924 T2 | 19-03-1998 |
| | | | EP | 0706726 A1 | 17-04-1996 |
| | | | JP | H08512192 A | 17-12-1996 |
| | | | US | 5361183 A | 01-11-1994 |
| | | | WO | 9501666 A1 | 12-01-1995 |
| KR 20110048831 | A | 12-05-2011 | NONE | | |
| US 2014146424 | A1 | 29-05-2014 | CN | 103852993 A | 11-06-2014 |
| | | | EP | 2752981 A1 | 09-07-2014 |
| | | | JP | 5793132 B2 | 14-10-2015 |
| | | | JP | 2014107238 A | 09-06-2014 |
| | | | US | 2014146424 A1 | 29-05-2014 |
| US 2007208520 | A1 | 06-09-2007 | CA | 2644378 A1 | 20-09-2007 |
| | | | CN | 101395777 A | 25-03-2009 |
| | | | EP | 1989771 A1 | 12-11-2008 |
| | | | US | 2007208520 A1 | 06-09-2007 |
| | | | WO | 2007106253 A1 | 20-09-2007 |

EPO FORM P0459

For more details about this annex : see Official Journal of the European Patent Office, No. 12/82